# EUROPEAN PATENT APPLICATION

(11) **EP 4 593 573 A1**
(43) Date of publication of application: **30.07.2025**
(21) Application number: 23938736.8
(22) Date of filing: 26.05.2023
(51) Int. Cl.: H10K 59/38

(54) **DISPLAY DEVICE, DISPLAY PANEL, AND DISPLAY DEVICE MANUFACTURING METHOD**

(71) Applicant: BOE Technology Group Co., Ltd., Beijing 100015 (CN); Yunnan Invensight Optoelectronics Technology Co., Ltd., Kunming, Yunnan 650211 (CN)
(72) Inventor: YANG, Chao, Beijing 100176 (CN); SHAN, Qingshan, Beijing 100176 (CN); ZHANG, Fugang, Beijing 100176 (CN); BU, Weiliang, Beijing 100176 (CN); CHEN, Xiaochuan, Beijing 100176 (CN); TANG, Yingsen, Beijing 100176 (CN); GAO, Lianlong, Beijing 100176 (CN); WANG, Zhiqiang, Beijing 100176 (CN); FANG, Lei, Beijing 100176 (CN); HUA, Xiaowei, Beijing 100176 (CN); YANG, Zongshun, Beijing 100176 (CN)
(74) Representative: AWA Sweden AB
(86) International application number: PCT/CN2023/096631
(87) International publication number: WO 2024/243737

(57) **Abstract**

A display device, a method for manufacturing a display device, and a display panel are provided. The display device includes: a base substrate; a plurality of light-emitting units on the base substrate, wherein the light-emitting unit has a first electrode, a second electrode, and a light-emitting layer located between the first electrode and the second electrode, and the first electrode is located between the light-emitting layer and the base substrate; an encapsulation layer covering the plurality of light-emitting units; and a color filter layer on a side of the encapsulation layer away from the base substrate, wherein the color filter layer includes a first surface and a second surface opposite to each other in a direction perpendicular to the base substrate, and a roughness of the first surface is greater than a roughness of the second surface.

## Description

### TECHNICAL FIELD

The present disclosure relates to a field of display technology, and in particular, to a display device, a method for manufacturing a display device, and a display panel.

### BACKGROUND

With a development of display technology, requirements for display apparatuses are becoming increasingly high. Display effects of the display apparatuses are largely related to structures of display devices, but currently most display devices cannot meet the growing demand for display effects from users.

### SUMMARY

Embodiments of the present disclosure provide a display device, a method for manufacturing a display device, and a display panel.

According to an aspect of the present disclosure, a display device is provided. The display device includes: a base substrate; a plurality of light-emitting units on the base substrate, wherein the light-emitting unit has a first electrode, a second electrode, and a light-emitting layer located between the first electrode and the second electrode, and the first electrode is located between the light-emitting layer and the base substrate; an encapsulation layer covering the plurality of light-emitting units; and a color filter layer on a side of the encapsulation layer away from the base substrate, wherein the color filter layer includes a first surface and a second surface opposite to each other in a direction perpendicular to the base substrate, and a roughness of the first surface is greater than a roughness of the second surface.

For example, a distance between the first surface and the base substrate is greater than a distance between the second surface and the base substrate.

For example, the color filter layer includes a plurality of color filters corresponding one-to-one with the plurality of light-emitting units; and wherein at least a portion of a surface of at least one of the plurality of color filters on a side of the at least one of the plurality of color filters away from the base substrate has a roughness greater than a roughness of a surface of any of others of the plurality of color filters on a side of the any of others of the plurality of color filters away from the base substrate.

For example, the plurality of color filters include a first color filter, a second color filter, and a third color filter; and wherein at least a portion of a surface of the first color filter on a side of the first color filter away from the base substrate has a roughness greater than a roughness of a surface of the second color filter on a side of the second color filter away from the base substrate and a roughness of a surface of the third color filter on a side of the third color filter away from the base substrate.

For example, the surface of the first color filter on the side of the first color filter away from the base substrate includes a first central region and a first edge region surrounding the first central region; and wherein a roughness of the first edge region is greater than the roughness of the surface of the second color filter on the side of the second color filter away from the base substrate and the roughness of the surface of the third color filter on the side of the third color filter away from the base substrate.

For example, a roughness of the surface of the first color filter on the side of the first color filter away from the base substrate decreases from an edge of the first color filter to a center of the first color filter, so that an average roughness of the first edge region of the first color filter is greater than an average roughness of the first central region of the first color filter.

For example, the roughness of the first central region is within a range of 50 nm to 150 nm, and the roughness of the first edge region is within a range of 150 nm to 200 nm.

For example, the surface of the second color filter on the side of the second color filter away from the base substrate includes a second central region and a second edge region surrounding the second central region, and a roughness of the second edge region is less than a roughness of the second central region.

For example, the roughness of the first edge region of the first color filter is greater than the roughness of the second central region of the second color filter.

For example, the surface of the third color filter on the side of the third color filter away from the base substrate has a substantially uniform roughness.

For example, a roughness of a second central region of the second color filter is greater than a roughness of the third color filter.

For example, the first color filter, the second color filter, and the third color filter are provided in a direction parallel to the base substrate and overlap with each other; and wherein a thickness difference between any two of the first color filter, the second color filter, and the third color filter is less than a width of an overlapping portion between the any two of the first color filter, the second color filter, and the third color filter, and the width of the overlapping portion is a dimension of the overlapping portion in the direction parallel to the base substrate.

For example, the first color filter is located between the second color filter and the third color filter, and partially covers the second color filter and the third color filter, so that a portion of the first color filter that covers the second color filter forms a first bump, and a portion of the first color filter that covers the third color filter forms a second bump.

For example, each of the first bump and the second bump has a lower surface facing the base substrate and an upper surface away from the base substrate; and wherein a roughness of the lower surface of the first bump is less than a roughness of the upper surface of the first bump, and a roughness of the lower surface of the second bump is less than a roughness of the upper surface of the second bump.

For example, the display device further includes: a plurality of lenses on a side of the color filter layer away from the base substrate, wherein the plurality of lenses correspond one-to-one with the plurality of light-emitting units.

For example, the display device further includes: a first planarization layer on a side of the color filter layer away from the base substrate; wherein the color filter layer includes a plurality of color filters corresponding one-to-one with the plurality of light-emitting units, the plurality of color filters are provided in a direction parallel to the base substrate and overlap with each other, and a ratio of a thickness of the first planarization layer to a width of an overlapping portion between any two of the plurality of color filters is within a range of 1 to 1.8.

For example, a plurality of lenses corresponding one-to-one with the plurality of color filters are provided on a side of the first planarization layer away from the base substrate.

For example, the display device further includes: a second planarization layer between the color filter layer and the encapsulation layer; wherein a thickness of the second planarization layer is less than the thickness of the first planarization layer, and a thickness difference between any two of the plurality of color filters is less than the thickness of the second planarization layer.

For example, an average thickness of the color filter layer is less than 1.3 µm, and a thickness difference between any two of the plurality of color filters is less than 100 nm.

For example, the first color filter is a green color filter, the second color filter is a red color filter, and the third color filter is a blue color filter.

According to another aspect of the present disclosure, a display device is further provided. The display device includes: a base substrate; a plurality of light-emitting units on the base substrate, wherein the light-emitting unit has a first electrode, a second electrode, and a light-emitting layer located between the first electrode and the second electrode, and the first electrode is located between the light-emitting layer and the base substrate; an encapsulation layer covering the plurality of light-emitting units; and a color filter layer on a side of the encapsulation layer away from the base substrate, wherein the color filter layer includes a first surface and a second surface opposite to each other in a direction perpendicular to the base substrate, each of the first surface and the second surface has micro bumps, a dimension of the micro bumps of the first surface is greater than a dimension of the micro bumps of the second surface, wherein the dimension of the micro bumps is a dimension of the micro bumps in the direction perpendicular to the base substrate.

For example, a distance between the first surface and the base substrate is greater than a distance between the second surface and the base substrate.

For example, the dimension of the micro bumps of the first surface is within a range of 5 nm to 20 nm.

For example, the color filter layer includes a first color filter, a second color filter, and a third color filter, and wherein the micro bumps of at least a portion of a surface of the first color filter on a side of the first color filter away from the base substrate have a dimension greater than a dimension of the micro bumps of a surface of the second color filter on a side of the second color filter away from the base substrate and a dimension of the micro bumps of a surface of the third color filter on a side of the third color filter away from the base substrate.

For example, the surface of the first color filter on the side of the first color filter away from the base substrate includes a first central region and a first edge region surrounding the first central region; and wherein the micro bumps in the first edge region have a dimension greater than the dimension of the micro bumps of the surface of the second color filter on the side of the second color filter away from the base substrate and the dimension of the micro bumps of the surface of the third color filter on the side of the third color filter away from the base substrate.

For example, the micro bumps of the surface of the first color filter on the side of the first color filter away from the base substrate have dimensions decreased from an edge of the first color filter to a center of the first color filter, so that an average dimension of the micro bumps in the first edge region of the first color filter is greater than an average dimension of the micro bumps in the first central region of the first color filter.

For example, the surface of the second color filter on the side of the second color filter away from the base substrate includes a second central region and a second edge region surrounding the second central region; and wherein the micro bumps in the second edge region have a dimension less than a dimension of the micro bumps in the second central region, and the micro bumps in a first edge region of the first color filter have a dimension greater than the dimension of the micro bumps in the second central region of the second color filter.

For example, the micro bumps of the surface of the third color filter on the side of the third color filter away from the base substrate have a substantially same dimension, and the micro bumps in the second central region of the second color filter have a dimension greater than a dimension of the micro bumps of the third color filter.

For example, the first color filter, the second color filter, and the third color filter are provided in a direction parallel to the base substrate and overlap with each other; and wherein a thickness difference between any two of the first color filter, the second color filter, and the third color filter is less than a width of an overlapping portion between the any two of the first color filter, the second color filter, and the third color filter, and the width of the overlapping portion is a dimension of the overlapping portion in the direction parallel to the base substrate.

For example, the display device further includes a first planarization layer on a side of the color filter layer away from the base substrate, wherein the color filter layer includes a plurality of color filters corresponding one-to-one with the plurality of light-emitting units, the plurality of color filters are provided in a direction parallel to the base substrate and overlap with each other, and a ratio of a thickness of the first planarization layer to a width of an overlapping portion between any two of the plurality of color filters is within a range of 1 to 1.8; and a second planarization layer between the color filter layer and the encapsulation layer, wherein a thickness of the second planarization layer is less than the thickness of the first planarization layer, and a thickness difference between any two of the plurality of color filters is less than the thickness of the second planarization layer.

According to another aspect of the present disclosure, a display panel is further provided. The display panel includes a plurality of display devices, wherein the display device is the display device as described above.

For example, the display panel includes a display region and a peripheral region on at least one side of the display region, the display device is located in the display region, and a light shielding layer is provided in the peripheral region; and wherein the light shielding layer includes a plurality of sub-layers stacked in a direction perpendicular to the base substrate, each of the plurality of sub-layers is made of a material identical to a material of one of a plurality of color filters in the color filter layer, a roughness of a surface of a top sub-layer among the plurality of sub-layers on a side of the top sub-layer away from the base substrate is greater than a roughness of a surface of any of others of the plurality of sub-layers, and the top sub-layer is a sub-layer farthest from the base substrate among the plurality of sub-layers.

For example, the surface of the top sub-layer on the side of the top sub-layer away from the base substrate has a fourth central region and a fourth edge region surrounding the fourth central region, and a roughness of the fourth central region is greater than a roughness of the fourth edge region.

For example, the peripheral region surrounds the display region, and the light shielding layer extends along the peripheral region, so that a projection of the light shielding layer on the base substrate is in a shape of a circular strip.

According to another aspect of the present disclosure, a method for manufacturing the display device as described above is further provided. The method includes: forming a plurality of light-emitting units on the base substrate; forming an encapsulation layer covering at least one light-emitting unit; forming a color filter material layer on a side of the encapsulation layer away from the base substrate; coating a photosensitive material on the color filter material layer, so that the color filter material layer is completely covered by the photosensitive material; and removing the photosensitive material and a portion of the color filter material layer through an etch-back process to obtain a color filter layer, wherein the color filter layer includes a first surface and a second surface opposite to each other in a direction perpendicular to the base substrate, and a roughness of the first surface is greater than a roughness of the second surface.

For example, the method further includes: forming a plurality of lenses corresponding one-to-one with the plurality of light-emitting units on a side of the color filter layer away from the base substrate.

For example, the photosensitive material is a photoresist, and an etching selection ratio between the photoresist and a material of the color filter material layer is substantially 1:1.

For example, the removing the photosensitive material and a portion of the color filter material layer through an etch-back process includes: etching the color filter material layer coated with the photosensitive material until a thickness of the color filter material layer is reduced to a first thickness; and over-etching the color filter material layer with the first thickness until the thickness of the color filter material layer is further reduced to a second thickness.

For example, the method further includes: forming a first planarization layer on the color filter layer before forming a plurality of lenses.

### BRIEF DESCRIPTION OF THE DRAWINGS

FIG. 1 shows a schematic structural diagram of a display device according to embodiments of the present disclosure.
FIG. 2A shows a schematic diagram of a cross-section of a color filter according to embodiments of the present disclosure.
FIG. 2B shows a top view of a color filter according to embodiments of the present disclosure.
FIG. 3A shows a partial enlarged view of a display device according to an embodiment of the present disclosure.
FIG. 3B shows a partial enlarged view of a display device according to another embodiment of the present disclosure.
FIG. 4 shows a flowchart of a method for manufacturing a display device according to embodiments of the present disclosure.
FIGS. 5A to 5F show a manufacturing process of a display device according to embodiments of the present disclosure.
FIG. 6A shows a diagram of a measurement result of an H-direction color shift viewing angle of a display device with a lens in embodiments of the present disclosure.
FIG. 6B shows a diagram of a measurement result of a V-direction color shift viewing angle of a display device with a lens in embodiments of the present disclosure.
FIG. 7A shows a diagram of a measurement result of an H-direction color shift viewing angle of a display device without a lens in embodiments of the present disclosure.
FIG. 7B shows a diagram of a measurement result of a V-direction color shift viewing angle of a display device without a lens in embodiments of the present disclosure.
FIG. 8 shows a schematic cross-sectional view of a display panel in embodiments of the present disclosure.
FIG. 9 shows a schematic plan view of a display panel in embodiments of the present disclosure.

### DETAILED DESCRIPTION OF EMBODIMENTS

Although the present disclosure will be fully described with reference to accompanying drawings containing preferred embodiments in the present disclosure, prior to the description, it should be understood that those of ordinary skill in the art may modify the present disclosure while obtaining technical effects of the present disclosure. Therefore, it should be understood that the above description is a broad disclosure for those of ordinary skill in the art, and its content is not intended to limit exemplary embodiments described in the present disclosure.

In addition, in the detailed description below, for the sake of explanation, many specific details are elaborated to provide a comprehensive understanding of embodiments in the present disclosure. However, clearly, one or more embodiments can also be implemented without these specific details. In other cases, well-known structures and devices are illustrated to simplify the accompanying drawings.

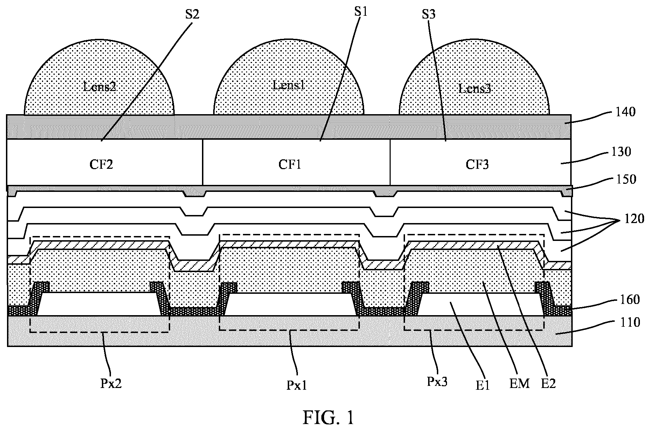

FIG. 1 shows a schematic structural diagram of a display device according to embodiments in the present disclosure. As shown in FIG. 1, the display device includes a base substrate 110, a plurality of light-emitting units Px1 to Px3, an encapsulation layer 120, and a color filter layer 130.

The plurality of light-emitting units Px1 to Px3 are located on the base substrate 110. Three light-emitting units Px1, Px2, and Px3 are shown in FIG. 1 for illustrative purposes. However, embodiments of the present disclosure are not limited to this, the display device may have any number of light-emitting units as desired. Each of the light-emitting units Px1, Px2, and Px3 has a first electrode E1, a second electrode E2, and a light-emitting layer EM located between the first electrode E1 and the second electrode E2. The first electrode E1 is located between the light-emitting layer EM and the base substrate 110.

The encapsulation layer 120 covers the plurality of light-emitting units Px1, Px2, and Px3. The encapsulation layer may be a multi-layer structure. In some embodiments, the encapsulation layer may include an organic and/or inorganic material, such as having a three-layer structure of SiN+Al₂O₃+SiN.

The color filter layer 130 is located on a side of the encapsulation layer 120 away from the base substrate 110. As shown in FIG. 1, the color filter layer 130 includes a first surface and a second surface opposite to each other in a direction perpendicular to the base substrate 110. A roughness of the first surface is greater than a roughness of the second surface. In other embodiments, each of the first surface and the second surface (upper and lower surfaces shown in FIG. 1) of the color filter layer 130 has micro bumps. A dimension of the micro bumps of the first surface is greater than a dimension of the micro bumps of the second surface. The dimension of the micro bumps refers to a dimension of the micro bumps in the direction perpendicular to the base substrate 110. In some embodiments, the dimension of the micro bumps Bm of the first surface of the color filter layer 130 is within a range of 5 nm to 20 nm.

A distance between the first surface of the color filter layer 130 and the base substrate 110 is greater than a distance between the second surface of the color filter layer 130 and the base substrate 110. For example, as shown in FIG. 1, the first surface is a surface of the color filter layer 130 on a side of the color filter layer 130 away from the base substrate 110, which is an upper surface. The second surface is a surface of the color filter layer 130 on a side of the color filter layer 130 facing the base substrate 110, which is a lower surface. In a process of forming the color filter layer 130, for example, a dry etching process may be added. In the dry etching process, the roughness of the upper surface increases due to undergoing dry etching, while the roughness of the lower surface remains unchanged due to not undergoing dry etching, so that the roughness of the upper surface of the color filter layer 130 is greater than that of the lower surface of the color filter layer 130. In some embodiments, the color filter layer 130 may include a plurality of color filters CF1, CF2, and CF3 corresponding one-to-one with the plurality of light-emitting units Px1, Px2, and Px3. In addition, the color filter layer 130 may further include a glass substrate, a black matrix BM, a protective layer OC, an ITO conductive film, a columnar spacer, etc. The composition and structure of the color filter layer may vary slightly depending on a display mode. The color filters CF1, CF2, and CF3 may be arranged as bars, dots, triangles, mosaics, or other specific patterns (such as similar portrait or animal pattern). Bar and dot arrangements are generally used for large-sized and high-precision products. Triangle and mosaic arrangements are generally used for small-sized and low-precision products. Chromaticity and transmittance are two major optical properties of the color filter layer, which mainly depend on the material of the color filter.

According to embodiments of the present disclosure, at least a portion of a surface of at least one of the plurality of color filters CF1, CF2, and CF3 on a side of the at least one of the plurality of color filters CF1, CF2, and CF3 away from the base substrate 110 has a roughness greater than a roughness of a surface of any of others of the plurality of color filters CF1, CF2, and CF3 on a side of the any of others of the plurality of color filters CF1, CF2, and CF3 away from the base substrate 110. For example, the color filter layer 130 may include a first color filter CF1, a second color filter CF2, and a third color filter CF3. The first color filter CF1 may be a green color filter, the second color filter CF2 may be a red color filter, and the third color filter CF3 may be a blue color filter. A surface of the first color filter CF1 on a side of the first color filter CF1 away from the base substrate 110 is represented by S1, a surface of the second color filter CF2 on a side of the second color filter CF2 away from the base substrate 110 is represented by S2, and a surface of the third color filter CF3 on a side of the third color filter CF3 away from the base substrate 110 is represented by S3. As shown in FIG. 1, the first surface of the color filter layer 130 may include respective surfaces S1, S2, and S3 of the color filters as described above. A roughness of the first surface of the color filter layer 130 may be an average value of roughnesses of the respective surfaces of the color filters. However, embodiments of the present disclosure are not limited to this. A calculation method for the roughness of the first surface of the color filter layer 130 may be determined according to desires. For example, the maximum one of roughnesses at various positions on the first surface of the color filter layer 130 may be used as the roughness of the first surface of the color filter layer 130; alternatively, an average roughness of a surface with the greatest roughness among the respective surfaces S1, S2, and S3 of the color filters in the color filter layer 130 may be used as the roughness of the first surface of the color filter layer 130, and so on. In some embodiments, at least a portion of the surface S1 of the first color filter CF1 has a roughness greater than that of the surface S2 of the second color filter CF2 and the surface S3 of the third color filter CF3. For example, at least the portion of the surface S1 of the first color filter CF1 has a roughness within a range of 150 nm to 200 nm, while the surface S2 of the second color filter CF2 and the surface S3 of the third color filter CF3 have a roughness of less than 100 nm. At present, the color filters of most display devices have a relatively low roughness after processing, usually less than 100 nm. This leads to poor uniformity of output light. Embodiments in the present disclosure implements a display device, in which the roughness of the first surface of the color filter layer 130 is greater than the roughness of the second surface of the color filter layer 130, thereby improving the uniformity of output light and the display effect by causing. For example, in some embodiments, at least a portion of the surface of at least one color filter in the color filter layer 130 has a roughness within a range of 150 nm to 200 nm, which to some extent improves the uniformity of the output light while balancing the brightness of the output light. In some embodiments, the average thickness of the color filter layer 130 is less than 1.3 µm, for example, within a range of 1.2 µm ± 0.1 µm. A thickness difference between any two of the color filters CF1, CF2, and CF3 in the color filter layer 130 may be less than 100 nm, for example, less than 60 nm.

In some embodiments, the display device may further include a plurality of lenses Lens1 to Lens3. The plurality of lenses Lens1 to Lens3 are located on a side of the color filter layer 130 away from the base substrate 110, and correspond one-to-one with the plurality of color filters CF1, CF2, and CF3. The so-called "correspond one-to-one" here refers to providing a corresponding lens on a side of each color filter away from the base substrate. The arrangement of the plurality of lenses Lens1 to Lens3 may be identical to the arrangement of the color filters CF1 to CF3, such as the bar arrangement, dot arrangement, triangle arrangement, or mosaic arrangement, etc. In this way, each light-emitting unit and corresponding color filter and lens above the light-emitting unit form a light-emitting structure. The light emitted by the light-emitting unit passes through the color filter, and becomes light with the color of the color filter, which is then converged by the lens to improve brightness. For example, the light-emitting units Px1 to Px3 emit white light, and then the white light passes through the color filters CF1 to CF3 with different colors, so as to form light with different colors for the display panel 100.

In some embodiments, the display device may further include a first planarization layer 140. The first planarization layer 140 is located on a side of the color filter layer 130 away from the base substrate 110. In some embodiments, the plurality of lenses Lens1 to Lens3 are provided, the first planarization layer 140 is located between the color filter layer 130 and the plurality of lenses Lens1 to Lens3, as shown in FIG. 1. The color filter layer 130 may be covered by the first planarization layer.

In some embodiments, the display device may further include a second planarization layer 150. The second planarization layer is located between the color filter layer 130 and the encapsulation layer 120. A thickness of the second planarization layer is less than a thickness of the first planarization layer, and a thickness difference between any two of the plurality of color filters is less than the thickness of the second planarization layer.

In some embodiments, a pixel defining layer 160 may be provided between the base substrate 110 and the light-emitting layer EM. The pixel defining layer 160 covers an edge of the first electrode (e.g. an anode) E1 of each of the light-emitting units Px1 to Px3. The pixel defining layer 160 is used to define the plurality of light-emitting units Px1 to Px3 in the display device.

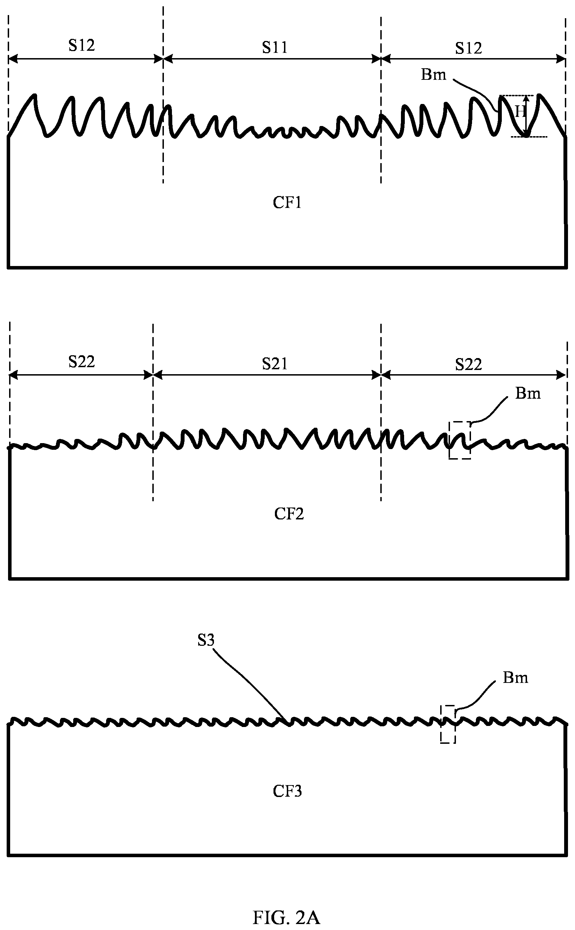

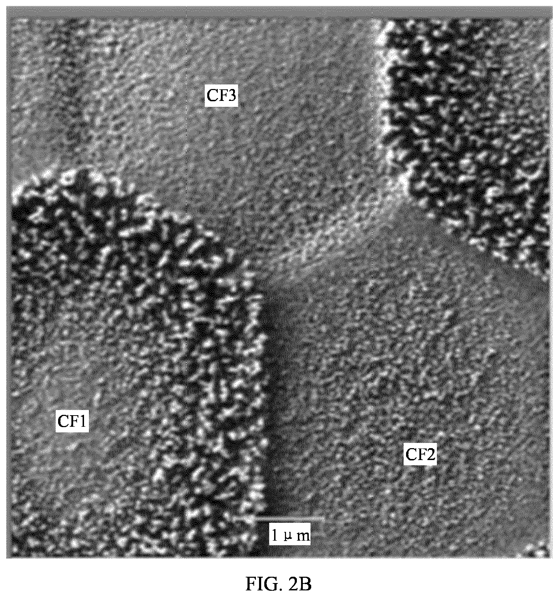

FIG. 2A shows a schematic diagram of a cross-section of a color filter according to embodiments of the present disclosure; FIG. 2B shows a top view of a color filter according to embodiments of the present disclosure.

As shown in FIGS. 2A and 2B, a surface of the first color filter CF1 on a side of the first color filter CF1 away from the base substrate 110 includes a first central region S11 and a first edge region S12 surrounding the first central region S11. A roughness of the first edge region S12 is greater than a roughness of the surface S2 of the second color filter CF2 and a roughness of the surface S3 of the third color filter CF3.

In some embodiments, the roughness of the first edge region S12 of the first color filter CF1 is greater than that of the first central region S11 of the first color filter CF1. For example, the roughness of the first edge region S12 is within a range of 150 nm to 200 nm, and the roughness of the first central region S11 is within a range of 50 nm to 150 nm. The roughness of the region of the surface here may refer to an average value of roughnesses; alternatively, it may refer to a roughness at a certain position, such as at any position in the region or at a geometric center of the region. Embodiments of the present disclosure do not limit this. In some embodiments, as shown in FIGS. 2A and 2B, a roughness of the surface S1 of the first color filter F1 on the side of the first color filter CF1 away from the base substrate 110 decreases from an edge of the first color filter CF1 to a center of the first color filter CF 1, so that an average roughness of the first edge region S12 of the first color filter CF1 is greater than an average roughness of the first central region S11 of the first color filter CF1. The surface S2 of the second color filter CF2 on the side of the second color filter CF2 away from the base substrate 110 may include a second central region S21 and a second edge region S22 surrounding the second central region S21. In some embodiments, as shown in FIGS. 2A and 2B, the roughness of the second edge region S22 is less than that of the second central region S21. In some embodiments, as shown in FIGS. 2A and 2B, the roughness of the first edge region S11 of the first color filter CF1 is greater than that of the second central region S21 of the second color filter CF2. The surface S3 of the third color filter CF3 on the side of the third color filter CF3 away from the base substrate 110 has a substantially uniform roughness. In some embodiments, the roughness of the second central region S21 of the second color filter CF2 is greater than the roughness of the third color filter CF3, as shown in FIGS. 2A and 2B.

In other embodiments, the surface of each of the color filters CF1 to CF3 on the side of the color filter away from the base substrate has micro bumps Bm, as shown in FIGS. 2A and 2B, only one micro bump Bm is marked for ease of description. In some embodiments, the dimension of the micro bumps Bm of the surface of each of the color filters CF1 to CF3 on the side of the color filter away from the base substrate 110 is within a range of 5 nm to 20 nm. As shown in FIG. 2A, the micro bumps Bm of at least a portion of the surface of the first color filter CF1 have a dimension greater than a dimension of the micro bumps Bm of the surface of the second color filter CF2 and a dimension of the micro bumps Bm of the surface of the third color filter CF3. The so-called "dimension of the micro bumps" here refers to a dimension of the micro bumps Bm in the direction perpendicular to the base substrate 110. For example, as shown in FIG. 2A, a distance H between the highest point and the lowest point on the surface of the micro bump Bm may be used as the dimension of the micro bump. The so-called "highest point" may be a point (also referred to as the vertex) on the surface of the micro bump Bm that is farthest from the base substrate 110, and the so-called "lowest point" may be a lowest point of a concave structure formed between adjacent micro bumps Bm. As shown in FIG. 2A, the micro bumps Bm in the first edge region S12 of the first color filter CF1 may have a dimension greater than the dimension of the micro bumps Bm in the first central region S11 of the first color filter CF1. The so-called dimension of the micro bumps in the region may be represented by an average value of dimensions of a plurality of micro bumps in the region; alternatively, it may be represented by a dimension of micro bump(s) at a certain position in the region, for example, a dimension of a micro bump or an average dimension of some micro bumps at any position in the region or at the geometric center of the region. Embodiments of the present disclosure do not limit this. In some embodiments, as shown in FIGS. 2A and 2B, the plurality of micro bumps Bm of the surface S1 of the first color filter CF1 on the side of the first color filter CF1 away from the base substrate 110 may have dimensions H decreased from the edge of the first color filter CF1 to the center of the first color filter CF1, which causes the average dimension of the micro bumps Bm in the first edge region S12 to be greater than the average dimension of the micro bumps Bm in the first central region S11. The micro bumps Bm in the second edge region S22 of the second color filter CF2 have a dimension less than the dimension of the micro bumps Bm in the second central region S21 of the second color filter CF2, and the micro bumps Bm in the first edge region S12 of the first color filter CF1 have a dimension greater than the dimension of the micro bumps Bm in the second central region S21 of the second color filter CF2. The micro bumps Bm of the surface S1 of the third color filter CF3 have substantially the same dimension, which may be less than the dimension of the micro bumps Bm in the second central region S21 of the second color filter CF2.

FIG. 2B shows a top view of the color filters CF1 to CF3, in which color filters CF1 to CF3 having hexagonal patterns are illustrated as an example. However, embodiments of the present disclosure are not limited to this. The patterns of the color filters CF1 to CF3 in the top view may be designed as desired, for example, each of the color filters CF1 to CF3 may have a pattern of rectangular, diamond, or others in top view.

The color filter layer in embodiments of the present disclosure undergoes an etch back process when forming the color filter layer. Due to the characteristics of the dry etching process, the surface of the color filter will become rough, especially there will be flocculent substances in the gap region between the color filters, as shown in FIG. 2B. In a process of etching various color filters, the edge of the first color filter is more etched, resulting in a large roughness of the surface, while the central region of the first color filter and the second and third color filters are less etched, resulting in a relatively smooth surface. The roughness of the surface of the color filter in embodiments of the present disclosure is significantly greater than that of existing display devices.

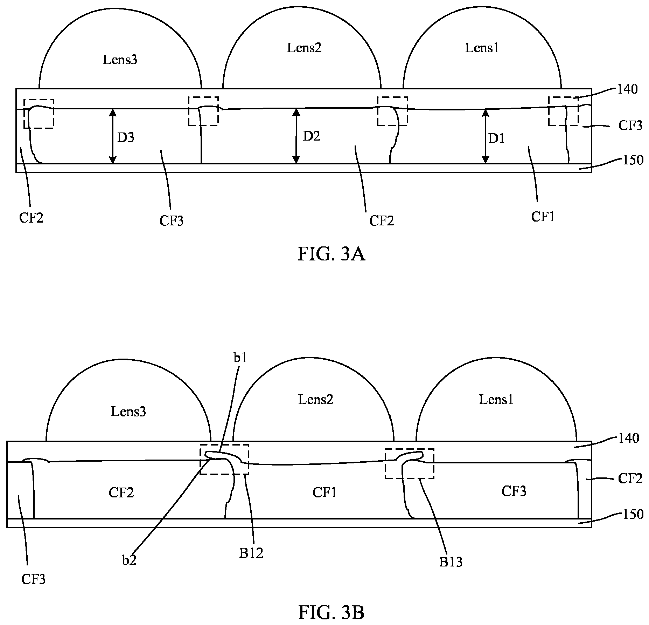

FIG. 3A shows a partial enlarged view of a display device according to an embodiment of the present disclosure. A plurality of display devices are shown in FIG. 3A, in each display device, various color filters are arranged in an order of CF1, CF2, and CF3, and are adjacent to each other, thereby forming a color filter layout in the display panel. However, embodiments of the present disclosure are not limited to this, the arrangement order of the color filters in each display device may be set as desired, for example, the second color filter CF2 is located between the first color filter CF1 and the third color filter CF3, or the first color filter CF1 is located between the second color filter CF2 and the third color filter CF3, etc. As shown in FIG. 3A, the first color filter CF1, the second color filter CF2, and the third color filter CF3 in the display device are arranged parallel to the base substrate 110 and overlap with each other. An overlapping portion (as shown in the dashed box in FIG. 3A) between any two of the first color filter CF1, the second color filter CF2, and the third color filter CF3 has a certain width. The so-called width here refers to a dimension in a direction parallel to the base substrate 110, which is a dimension in a horizontal direction in FIG. 3A. In the direction parallel to the base substrate, a curved interface is formed between adjacent color filters. In the direction perpendicular to the base substrate, a thickness difference between any two of the first color filter CF1, the second color filter CF2, and the third color filter CF3 is small, for example, the thickness difference may be less than the width of the overlapping portion between any two of the first color filter CF1, the second color filter CF2, and the third color filter CF3. In other words, a ratio of the thickness difference between any two of the first color filter CF1, the second color filter CF2, and the third color filter CF3 to the width of the overlapping portion is less than 1, for example, the ratio may be less than or equal to 0.8, or even less than or equal to 0.5. In some embodiments, the upper surfaces of the first color filter CF1 to the third color filter CF3 (i.e. the surfaces of the color filters on the side of the color filters away from the base substrate) may be substantially flush with each other, for example, a height difference between the upper surfaces of various color filters may be controlled at around 100 nm. For example, the first color filter CF1, the second color filter CF2, and the third color filter CF3 may have thicknesses D1, D2, and D3, respectively, and a difference between any two of the thicknesses D1, D2, and D3 is less than 100 nm. For example, D1, D2, and D3 may be within a range of 1.1 µm to 1.3 µm. In some embodiments, D1<D2<D3. In some embodiments, the difference between D1 and D2 is within a range of 10 nm to 30 nm, and the difference between D2 and D3 is within a range of 20 nm to 50 nm. The so-called thickness of the color filter here may refer to an average thickness of the color filter; or refer to a thickness of the color filter at a certain position, such as a thickness at a geometric center of the color filter; or refer to a maximum or minimum thickness of the color filter. In some embodiments, a ratio of the thickness of the first planarization layer 140 to the width of the overlapping portion between any two of the plurality of color filters CF1 to CF3 is within a range of 1 to 1.8. That is to say, the thickness of the first planarization layer 140 is greater than the width of the overlapping portion between any two of the color filters CF1 to CF3, and less than 1.8 times the width of the overlapping portion.

FIG. 3B shows a partial enlarged view of a display device according to another embodiment of the present disclosure. As shown in FIG. 3B, the first color filter CF1, the second color filter CF2, and the third color filter CF3 in the display device are also arranged in the direction parallel to the base substrate 110. The first color filter CF1 is located between the second color filter CF2 and the third color filter CF3. Unlike that shown in FIG. 3A, the first color filter CF1 shown in FIG. 3B partially covers the second color filter CF2 and the third color filter CF3, so that a portion of the first color filter CF1 that covers the second color filter CF2 forms a first bump B12, and a portion of the first color filter CF1 that covers the third color filter CF3 forms a second bump B21. In some embodiments, each of the first bump b1 and the second bump b2 has a lower surface b2 facing the base substrate and an upper surface b1 away from the base substrate. A roughness of the lower surface b2 is less than a roughness of the upper surface b1. This is because the color filter layer undergoes an etch back process when forming the color filter layer, so that the roughness of the etched upper surface b1 is greater than the roughness of the un-etched lower surface b2. In some embodiments, the second color filter CF2 also covers an edge of the third color filter CF3 in an adjacent display device. The coverage relationship between the first, second, and third color filters depends on the order in which they are formed. For example, in a process of manufacturing various display devices, the third color filter is formed, then the second color filter is formed, and then the first color filter is formed. The second color filter formed after the third color filter covers the edge of the third color filter, and the first color filter formed after the second color filter fills a gap between the second and third color filters, and covers the edges of adjacent second and third color filters.

Other embodiments of the present disclosure further provide a display panel including the display device as described above. The display panel is a panel that may display information such as text, images, or videos. Examples of display panels include liquid crystal display panels (LCDs), organic light-emitting diode (OLED) display panels, silicon-based organic light-emitting diode (OLEDoS) display panels, plasma display panels, etc.

Embodiments of the present disclosure further provide a method for manufacturing the display device. The method is applicable to manufacturing the display device of any of above embodiments.

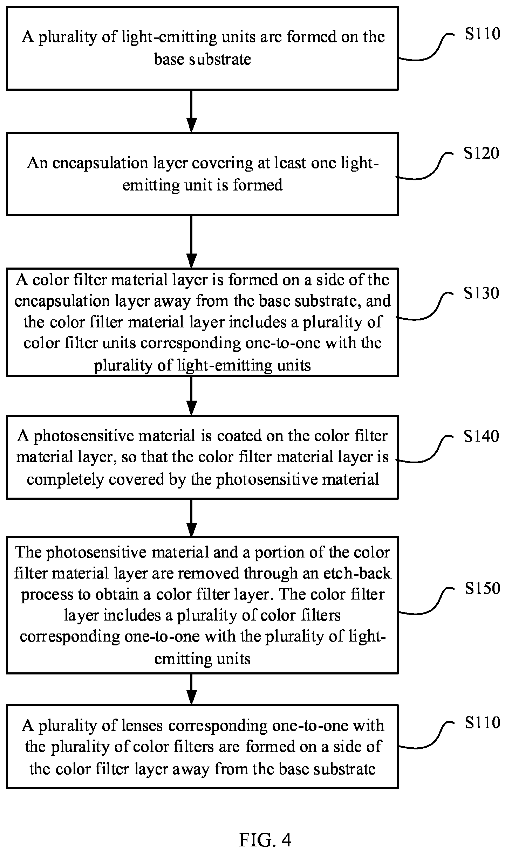

FIG. 4 shows a flowchart of a method for manufacturing a display device according to embodiments of the present disclosure.

In step S110, a plurality of light-emitting units are formed on the base substrate.

In step S120, an encapsulation layer covering at least one light-emitting unit is formed.

In step S130, a color filter material layer is formed on a side of the encapsulation layer away from the base substrate, and the color filter material layer includes a plurality of color filter units corresponding one-to-one with the plurality of light-emitting units.

In step S140, a photosensitive material is coated on the color filter material layer, so that the color filter material layer is completely covered by the photosensitive material. In some embodiments, the photosensitive material may be a photoresist, and an etching selection ratio between the photoresist and a material of the color filter material layer may be substantially 1:1.

In step S150, the photosensitive material and a portion of the color filter material layer are removed through an etch-back process to obtain a color filter layer. The color filter layer includes a plurality of color filters corresponding one-to-one with the plurality of light-emitting units. Dry etching may be used in the etch-back process. In some embodiments, etching may be performed on the color filter material layer coated with photosensitive material until a thickness of the color filter material layer is reduced to a first thickness; and then the color filter material layer with the first thickness is over-etched until the thickness of the color filter material layer is further reduced to a second thickness.

In some embodiments, after performing step S150, step S160 may be further performed to form a plurality of lenses corresponding one-to-one with the plurality of color filters on a side of the color filter layer away from the base substrate.

In some embodiments, after performing step S150, a first planarization layer may be further formed on the color filter layer obtained in step S150. Afterwards, proceed to step S160 so that the first planarization layer is located between the color filter layer and the plurality of lenses.

In some embodiments, a second planarization layer may be further formed on the encapsulation layer before performing step S130. Then, performing step S130 to form the color filter material layer on the second planarization layer.

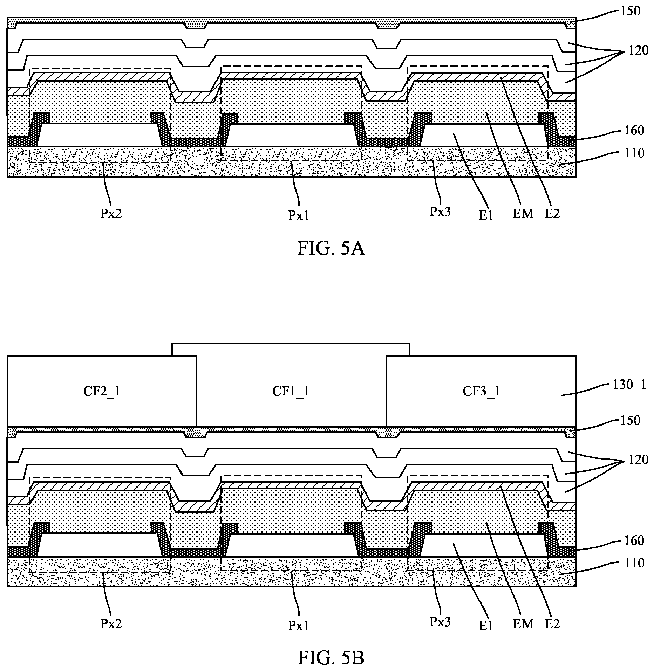

Hereinafter, an example will be provided to illustrate the method for manufacturing the display device in embodiments of the present disclosure with reference to FIGS. 5A to 5F.

As shown in FIG. 5A, a plurality of light-emitting units Px1 to Px3, an encapsulation layer 120, and a second planarization layer 150 are sequentially formed on the base substrate 110.

Then, a color filter material layer 130_1 is formed on the structure shown in FIG. 5A, resulting in the structure shown in FIG. 5B. As shown in FIG. 5B, the color filter material layer 130_1 may include a plurality of color filter units CF1_1, CF1_2, and CF1_3 corresponding one-to-one with the plurality of light-emitting units Px1 to Px3. For example, the plurality of color filter units CF1_1, CF1_2, and CF1_3 may be made of a green color filter material, a red color filter material, and a blue color filter material, respectively. The green color filter unit CF1_1 covers a portion of the red color filter unit CF1_2 and the blue color filter unit CF1_3 on both sides of the green color filter unit CF1_1, so as to form bumps on both sides.

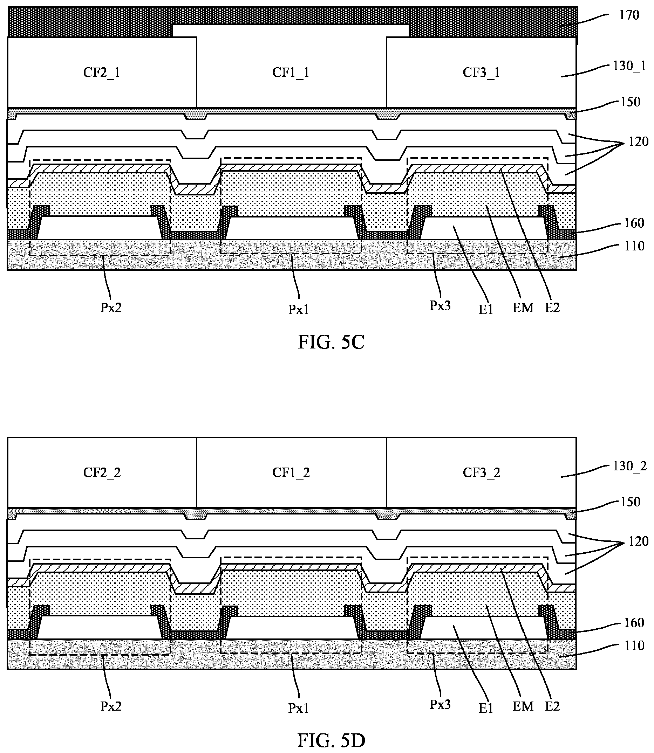

Next, as shown in FIG. 5C, a photosensitive material 170 is coated on the color filter material layer 130_1, so that the color filter material layer 130_1 is completely covered by the photosensitive material 170. This process may be achieved by performing above step S140. A thickness of the photosensitive material 170 is greater than heights of the bumps on both sides of the color filter unit CF_1 in the color filter material layer 130, so that the photosensitive material 170 may completely cover the color filter material layer 130_1 for subsequent etching. The etching selection ratio between the photosensitive material 170 and the material of the color filter material layer 1301 is substantially 1:1, so that in the subsequent etching process, the etching rate of each color filter unit in the color filter material layer is substantially equal to the etching rate of the photosensitive material. In practical operations, due to the difference between any two of the materials of the color filter units, there is a slight difference between any two of the etching rates of the color filter units, and this substantially does not affect the expected flatness of the entire color filter material layer.

Next, as shown in FIG. 5D, etching is performed on the photosensitive material 170 and the color filter material layer 130_1 covered by the photosensitive material 170 shown in FIG. 5C until a thickness of the color filter material layer 130_1 is reduced to the first thickness, thereby obtaining the color filter material layer 130_2 with the first thickness. The first thickness may be within a range of 1.4 µm ± 0.1 µm.

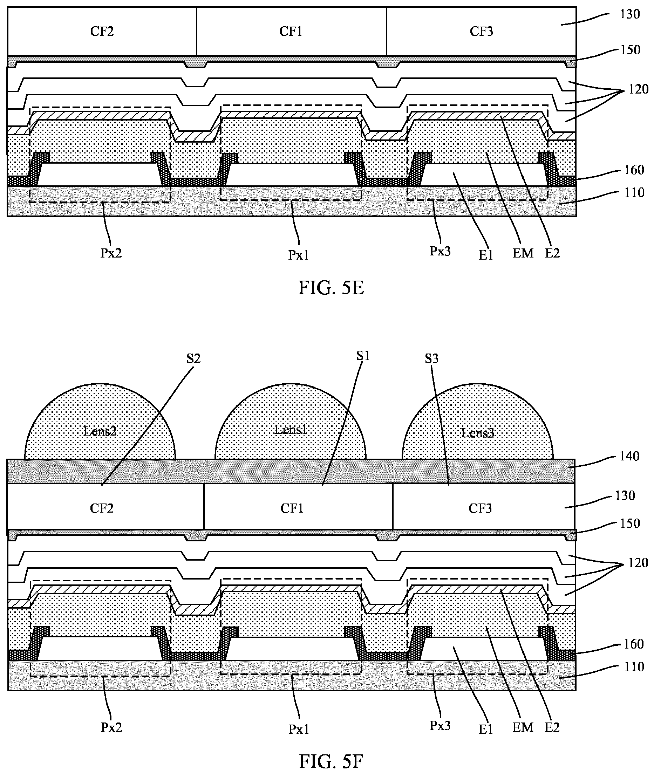

Next, as shown in FIG. 5E, the color filter material layer 130_2 with the first thickness is over-etched until the thickness of the color filter material layer 130_2 is further reduced to the second thickness, thereby obtaining the color filter layer 130 with the second thickness. The color filter layer 130 has a structure as described in any of the above embodiments. In some embodiments, the second thickness may be within a range of 1.2 µm ± 0.1 µm. By performing over-etching, residual photoresist may be removed and the flatness of the color filter layer may be further improved. The etching depth may be set as needed to obtain the desired surface structure of the color filter layer. For example, the bumps (also referred to as the bull horn structures) on both sides of the color filter unit CF_1 in the color filter material layer may be completely removed, thereby obtaining the surface of the color filter layer with a relatively high flatness as shown in FIG. 3A. As another example, the bumps (also referred to as the bull horn structures) on both sides of the color filter unit CF_1 in the color filter material layer may be partially removed, thereby obtaining the surface of the color filter layer with a relatively low flatness as shown in FIG. 3B. In the etching process described with reference to FIGS. 5C to 5E above, the exposed upper surface of the color filter material layer undergoes dry etching, while the lower surface of the color filter material layer does not undergo dry etching. Therefore, the roughness of the upper surface of the obtained color filter layer 130 is greater than that of the lower surface of the obtained color filter layer 130.

Next, as shown in FIG. 5F, a first planarization layer 140 is formed on the color filter layer 130, and then a plurality of lenses Lens1, Lens2, and Lens3 corresponding one-to-one with the plurality of color filters CF1, CF2, and CF3 are formed on the first planarization layer 140. In some embodiments, when the flatness of the color filter layer 130 meets the requirements, it is not necessary to form the first planarization layer, but the plurality of lenses Lens1, Lens2, and Lens3 are formed on the color filter layer 130.

In display technology, color shift is an important indicator for evaluating the performance of the display apparatus. If the color shift viewing angle of the display apparatus is small, it is more likely to cause color shift phenomena such as redness and greenness as the viewing angle increases, which affects the visual effect. In the display device, especially in the high PPI display device such as the silicon-based organic light-emitting diode (OLEDoS, OLED on silicon), there is inevitably a height difference between the surfaces of the color filters corresponding to different pixels, resulting in the color filter having a shape similar to a bull horn in cross-section (concave in the middle and raised at the edge), and the height difference is also referred to as the bull horn height or missmatch discrepancy. Such missmatch discrepancy is usually within a range of 300 nm to 630 nm, resulting in differences in the output light effects of the color filters with different colors under lateral viewing angles. The color shift difference Δu'v'<0.025 corresponds to a viewing angle of less than about 17°. In addition, the color filters are usually formed in multiple stages, and the color filter may have a shape of a concave lens when filling the gap between the previous formed color filters, resulting in the color shift at large viewing angles. To ensure that the color gamut DCI-P3 is greater than or equal to 80% while ensuring transparency and brightness, the thickness of the color filter in the weak cavity process is usually within a range of about 1.3±0.1 µm.

In embodiments of the present disclosure, by adopting the etch back process after forming the color filter material layer, the bull horn missmatch discrepancy may be reduced or even removed, thereby improving the flatness of the surface of the color filter layer and alleviating the problem of color shift. After test, it has been proven that the height of the missmatch discrepancy between different color filters may be controlled within 100 nm. In addition, in an existing display device, due to the poor flatness of the surface of the color filter, especially the height of the bull horn missmatch discrepancy is relatively high, multiple processes for forming the planarization layer are required to remove the missmatch discrepancy. The display device in embodiments of the present disclosure improves the flatness of the surface of the color filter layer, thereby reducing the number of times the planarization layer is formed, even omitting the planarization layer on the surface of the color filter layer, and simplifying the structure of the device. Moreover, the etch back process improves the roughness of the surface of the color filter layer, the brightness and the uniformity of the output light are balanced, thereby improving the display effect.

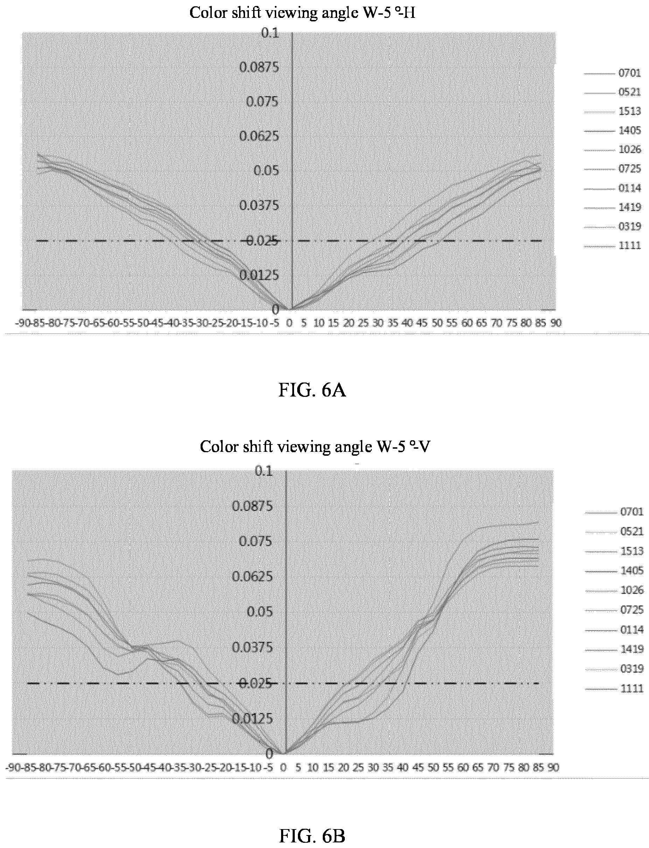

FIG. 6A shows a diagram of a measurement result of an H-direction color shift viewing angle of a display device with a lens in embodiments of the present disclosure. FIG. 6B shows a diagram of a measurement result of a V-direction color shift viewing angle of a display device with a lens in embodiments of the present disclosure. As shown in FIGS. 6A and 6B, for the display device in embodiments of the present disclosure, when the thickness of the color filter layer is within a range of 1.2±0.1 µm, a color shift viewing angle corresponding to the H-direction Δu'v'<0.025 is within a range of about ±40°, which is significantly improved compared to existing structures. When the thickness of the color filter layer of the display device in embodiments of the present disclosure is above 1.2 µm, the color gamut is greater than 80%. The display device in embodiments of the present disclosure may still ensure brightness and color spot specifications while considering color spots and transmittance comprehensively. After verification, the complete set of basic optical data and color shift viewing angle measurement data at different positions of the Wafer of the display device in embodiments of the present disclosure are superior to the baseline condition (in which the color shift viewing angle corresponding to Δu'v'<0.025 is within a range of ±20°).

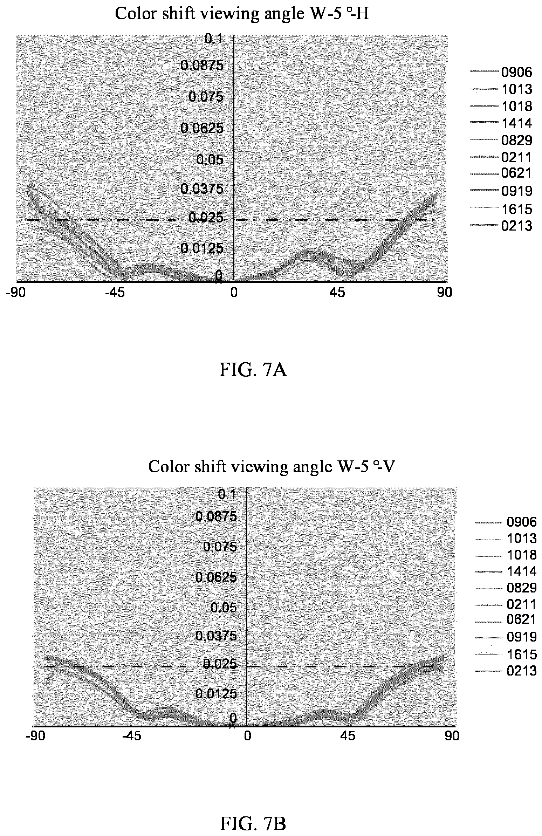

FIG. 7A shows a diagram of a measurement result of an H-direction color shift viewing angle of a display device without a lens in embodiments of the present disclosure. FIG. 7B shows a diagram of a measurement result of a V-direction color shift viewing angle of a display device without a lens in embodiments of the present disclosure. As shown in FIGS. 7A and 7B, compared to the color shift viewing angle of the display device with the lens shown in FIGS. 6A and 6B, the color shift viewing angle of the display device without the lens is significantly increased, reaching about 70°. It can be seen that removing the lens is beneficial for further alleviating color shift.

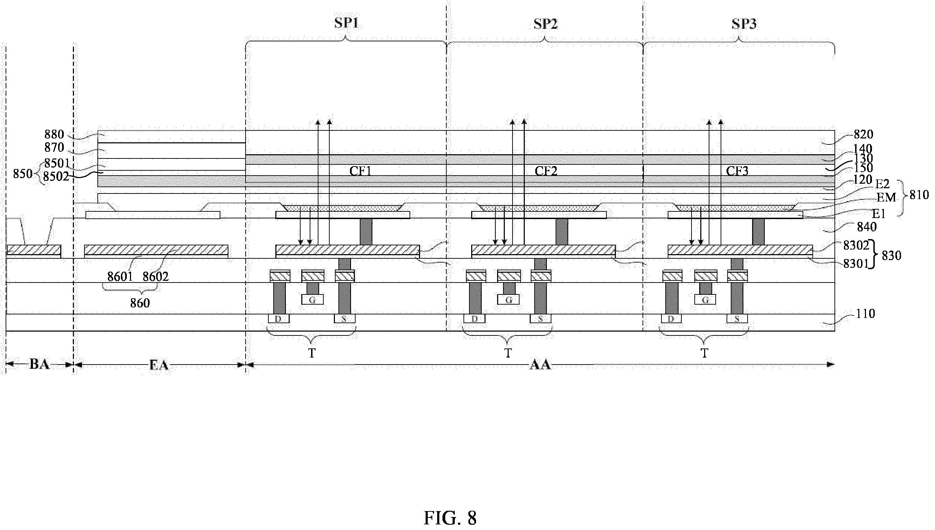

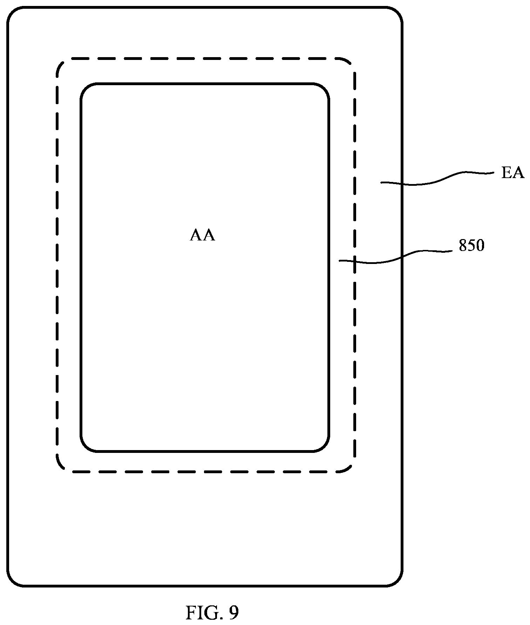

FIG. 8 shows a schematic cross-sectional view of a display panel in embodiments of the present disclosure. FIG. 9 shows a schematic plan view of a display panel in embodiments of the present disclosure.

The display panel in embodiments of the present disclosure may include a plurality of display devices, each of the plurality of display devices may be implemented by the display device in any of above embodiments. For the convenience of description, only one display device is shown in FIG. 8, which includes a plurality of sub-pixels SP1, SP2, and SP3. As shown in FIG. 8, each of the sub-pixels SP1, SP2, and SP3 includes a corresponding light-emitting unit 810, and each light-emitting unit includes a first electrode E1, a second electrode E2, and a light-emitting layer EM located between the first electrode E1 and the second electrode E2. The encapsulation layer 120, the second planarization layer 150, the color filter layer 130, and the first planarization layer 140 are sequentially stacked on the light-emitting unit 810. The light generated by the light-emitting unit 810 has corresponding colors after passing through the color filters CF1, CF2, and CF3. For example, the light passing through the color filter CF1 is green, the light passing through the color filter CF2 is red, and the light passing through the color filter CF3 is blue. A lens layer 820 may be further provided on the first planarization layer 140, and the lens layer 820 may include a plurality of lenses as described above, which will not be repeated here.

As shown in FIG. 8, the display panel includes a display region AA and a peripheral region EA located on at least one side of the display region AA. Each display device is located in the display region AA, for example, the display device including the sub-pixels SP1, SP2, and SP3 are provided in the display region AA. In some embodiments, each of the sub-pixels SP1, SP2, and SP3 may include a transistor T in addition to the light-emitting unit 810. The transistor T has a gate G, a source S, and a drain D, and at least one of the source S and the drain D is coupled to the first electrode E1 (in this embodiment, the first electrode E1 may be an anode) of the light-emitting unit 810 through a conductor layer 830. In some embodiments, the conductor layer 830 may include a first sub-layer 8301 and a second sub-layer 8302, which will not be repeated here. The conductor layer 830 may also play a reflective role. The light generated by the light-emitting layer EM in the light-emitting unit 810 is reflected by the conductor layer 830 and then penetrates the color filter layer 130 to emit. In some embodiments, a dielectric layer 840 may be further provided between the conductor layer 830 and the light-emitting unit 810.

As shown in FIG. 8, a light shielding layer 850 is provided in the peripheral region EA of the display panel, the light shielding layer 850 includes a plurality of sub-layers, such as sub-layers 8501 and 8502, stacked in the direction perpendicular to the base substrate 10. The number of sub-layers may be not limited to two, for example, the number of sub-layers may also be three, four, or more. Each of the sub-layers 8501 and 8502 is made of a material identical to a material of one of the plurality of color filters CF1, CF2, and CF3 in the color filter layer 130. For example, the sub-layer 8501 may be made of a material identical to a material of the color filter CF1, for example, both are made of a green color filter material. The sub-layer 8502 may be made of a material identical to a material of the color filter CF2, for example, both are made of a red color filter material. The stacking of the sub-layers 8501 and 8502 of different colors has a function of light shielding, thereby preventing light from the display region AA from leaking out from the peripheral region. In some embodiments, in order to enhance the light shielding effect, the light shielding layer 850 may include more sub-layers, such as blue sub-layers in addition to green and red sub-layers. In some embodiments, a roughness of a surface of a top sub-layer among the sub-layers of the light shielding layer 850 on a side of the top sub-layer away from the base substrate 110 is greater than a roughness of a surface of any of others of the sub-layers of the light shielding layer 850. Here, the so called top sub-layer (which is the sub-layer 8501 shown in FIG. 8) is a sub-layer farthest from the base substrate 110 among the plurality of sub-layers. In some embodiments, the surface of the top sub-layer 8501 on the side of the top sub-layer 8501 away from the base substrate 110 has a fourth central region and a fourth edge region surrounding the fourth central region, and a roughness of the fourth central region is greater than a roughness of the fourth edge region. In some embodiments, a conductor layer 860 may be further provided in the peripheral region EA, and two sub-layers 8601 and 8602 of the conductor layer 860 may be respectively arranged in the same layers as the two sub-layers 8301 and 8302 of the conductor layer 830 in the display region AA. In some embodiments, the display panel may further include a boundary region BA located on at least one side of the peripheral region, which will not be repeated here. In some embodiments, the peripheral region EA surrounds the display region AA, and the light shielding layer 850 extends along the peripheral region EA, so that a projection of the light shielding layer 850 on the base substrate 110 is in a shape of a circular strip, as shown in FIG. 9.

In the process of forming the color filter material layer as shown in FIG. 5A, the third color filter material layer, for example, the blue color filter material layer, may be formed in the display region AA and the peripheral region EA, then the second color filter material layer, for example, the red color filter material layer is formed, and then the first color filter material layer, for example, the green color filter material layer, may be formed. Later, the first color filter material layer will be used to form the sub-layer 8502 and the color filter CF2, the second color filter material layer will be used to form the sub-layer 8501 and the color filter CF1, and the third color filter material layer will be used to form the color filter CF3. In the display region AA, the first to third color filter material layers are alternately arranged, in order to form the three types of color filters in the future. In the peripheral region EA, the first and second color filter material layers are stacked, in order to form the stacked sub-layers of the light shielding layer in the future.

In the etch back process shown in FIGS. 5C to 5E, the exposed upper surfaces of the first to third color filter material layers in the display region AA are subjected to dry etching to obtain the surface structures shown in FIGS. 2A and 2B. The last formed first color filter material layer is exposed most, so it is etched to a relatively greater extant, resulting in a relatively larger surface roughness. In the peripheral region EA, due to the stacking of the first and second color filter material layers, the upper surface of the first color filter material layer located at the top undergoes dry etching, resulting in a relatively large roughness of the upper surface of the first sub-layer 8501. The second color filter material layer below does not undergo dry etching, therefore the roughness of the surface (whether it is the upper or lower surface) of the obtained second sub-layer 8503 is relatively small. In the display region AA, as shown in FIGS. 3A and 3B, the thickness of the central region of each of the color filters CF1 to CF3 arranged alternatively is less than the thickness of the edge region of each of the color filters CF1 to CF3. In the peripheral region EA, the stacking of the first sub-layer 8501 and the second sub-layer 8502 causes the light shielding layer 850 to have a structure with a thick center and thin edges. Accordingly, the central region of the upper surface of the first sub-layer 8501 located at the top undergoes more etching than the edge region of the upper surface of the first sub-layer 8501, so that a roughness of the surface of the central region is greater than a roughness of the surface of the edge region. In above embodiments, sub-pixels of three colors are used as examples for illustration. However, embodiments of the present disclosure are not limited to this, and are applicable to sub-pixels of more colors.

Those skilled in the art may understand that embodiments described above are exemplary, and those skilled in the art may improve them. The structures described in various embodiments can be freely combined without structural or principle conflicts.

After elaborating on preferred embodiments of the present disclosure, those skilled in the art can clearly understand that various changes and approaches can be made without departing from the scope and spirit of the appended claims, and the present disclosure is not limited to the implementation methods of the exemplary embodiments cited in the specification.

## Claims

1. A display device, comprising:
a base substrate;
a plurality of light-emitting units on the base substrate, wherein the light-emitting unit has a first electrode, a second electrode, and a light-emitting layer located between the first electrode and the second electrode, and the first electrode is located between the light-emitting layer and the base substrate;
an encapsulation layer covering the plurality of light-emitting units; and
a color filter layer on a side of the encapsulation layer away from the base substrate, wherein the color filter layer comprises a first surface and a second surface opposite to each other in a direction perpendicular to the base substrate, and a roughness of the first surface is greater than a roughness of the second surface.

2. The display device according to claim 1, wherein a distance between the first surface and the base substrate is greater than a distance between the second surface and the base substrate.

3. The display device according to claim 1 or 2, wherein the color filter layer comprises a plurality of color filters corresponding one-to-one with the plurality of light-emitting units; and
wherein at least a portion of a surface of at least one of the plurality of color filters on a side of the at least one of the plurality of color filters away from the base substrate has a roughness greater than a roughness of a surface of any of others of the plurality of color filters on a side of the any of others of the plurality of color filters away from the base substrate.

4. The display device according to any one of claims 1 to 3, wherein the plurality of color filters comprise a first color filter, a second color filter, and a third color filter; and
wherein at least a portion of a surface of the first color filter on a side of the first color filter away from the base substrate has a roughness greater than a roughness of a surface of the second color filter on a side of the second color filter away from the base substrate and a roughness of a surface of the third color filter on a side of the third color filter away from the base substrate.

5. The display device according to claim 4, wherein the surface of the first color filter on the side of the first color filter away from the base substrate comprises a first central region and a first edge region surrounding the first central region; and
wherein a roughness of the first edge region is greater than the roughness of the surface of the second color filter on the side of the second color filter away from the base substrate and the roughness of the surface of the third color filter on the side of the third color filter away from the base substrate.

6. The display device according to claim 5, wherein a roughness of the surface of the first color filter on the side of the first color filter away from the base substrate decreases from an edge of the first color filter to a center of the first color filter, so that an average roughness of the first edge region of the first color filter is greater than an average roughness of the first central region of the first color filter.

7. The display device according to claim 4, wherein the roughness of the first central region is within a range of 50 nm to 150 nm, and the roughness of the first edge region is within a range of 150 nm to 200 nm.

8. The display device according to any one of claims 4 to 7, wherein the surface of the second color filter on the side of the second color filter away from the base substrate comprises a second central region and a second edge region surrounding the second central region, and a roughness of the second edge region is less than a roughness of the second central region.

9. The display device according to claim 8, wherein the roughness of the first edge region of the first color filter is greater than the roughness of the second central region of the second color filter.

10. The display device according to any one of claims 4 to 9, wherein the surface of the third color filter on the side of the third color filter away from the base substrate has a substantially uniform roughness.

11. The display device according to claim 10, wherein a roughness of a second central region of the second color filter is greater than a roughness of the third color filter.

12. The display device according to any one of claims 4 to 11, wherein the first color filter, the second color filter, and the third color filter are provided in a direction parallel to the base substrate and overlap with each other; and
wherein a thickness difference between any two of the first color filter, the second color filter, and the third color filter is less than a width of an overlapping portion between the any two of the first color filter, the second color filter, and the third color filter, and the width of the overlapping portion is a dimension of the overlapping portion in the direction parallel to the base substrate.

13. The display device according to any one of claims 4 to 11, wherein the first color filter is located between the second color filter and the third color filter, and partially covers the second color filter and the third color filter, so that a portion of the first color filter that covers the second color filter forms a first bump, and a portion of the first color filter that covers the third color filter forms a second bump.

14. The display device according to claim 13, wherein each of the first bump and the second bump has a lower surface facing the base substrate and an upper surface away from the base substrate; and
wherein a roughness of the lower surface of the first bump is less than a roughness of the upper surface of the first bump, and a roughness of the lower surface of the second bump is less than a roughness of the upper surface of the second bump.

15. The display device according to any one of claims 1 to 14, further comprising: a plurality of lenses on a side of the color filter layer away from the base substrate, wherein the plurality of lenses correspond one-to-one with the plurality of light-emitting units.

16. The display device according to any one of claims 1 to 15, further comprising: a first planarization layer on a side of the color filter layer away from the base substrate;
wherein the color filter layer comprises a plurality of color filters corresponding one-to-one with the plurality of light-emitting units, the plurality of color filters are provided in a direction parallel to the base substrate and overlap with each other, and a ratio of a thickness of the first planarization layer to a width of an overlapping portion between any two of the plurality of color filters is within a range of 1 to 1.8.

17. The display device according to claim 16, wherein a plurality of lenses corresponding one-to-one with the plurality of color filters are provided on a side of the first planarization layer away from the base substrate.

18. The display device according to claim 16, further comprising: a second planarization layer between the color filter layer and the encapsulation layer;
wherein a thickness of the second planarization layer is less than the thickness of the first planarization layer, and a thickness difference between any two of the plurality of color filters is less than the thickness of the second planarization layer.

19. The display device according to any one of claims 1 to 18, wherein an average thickness of the color filter layer is less than 1.3 µm, and a thickness difference between any two of the plurality of color filters is less than 100 nm.

20. The display device according to any one of claims 4 to 19, wherein the first color filter is a green color filter, the second color filter is a red color filter, and the third color filter is a blue color filter.

21. A display device comprising:
a base substrate;
a plurality of light-emitting units on the base substrate, wherein the light-emitting unit has a first electrode, a second electrode, and a light-emitting layer located between the first electrode and the second electrode, and the first electrode is located between the light-emitting layer and the base substrate;
an encapsulation layer covering the plurality of light-emitting units; and
a color filter layer on a side of the encapsulation layer away from the base substrate, wherein the color filter layer comprises a first surface and a second surface opposite to each other in a direction perpendicular to the base substrate, each of the first surface and the second surface has micro bumps, a dimension of the micro bumps of the first surface is greater than a dimension of the micro bumps of the second surface, wherein the dimension of the micro bumps is a dimension of the micro bumps in the direction perpendicular to the base substrate.

22. The display device according to claim 21, wherein a distance between the first surface and the base substrate is greater than a distance between the second surface and the base substrate.

23. The display device according to claim 21 or 22, wherein the dimension of the micro bumps of the first surface is within a range of 5 nm to 20 nm.

24. The display device according to any one of claims 21 to 23, wherein the color filter layer comprises a first color filter, a second color filter, and a third color filter, and
wherein the micro bumps of at least a portion of a surface of the first color filter on a side of the first color filter away from the base substrate have a dimension greater than a dimension of the micro bumps of a surface of the second color filter on a side of the second color filter away from the base substrate and a dimension of the micro bumps of a surface of the third color filter on a side of the third color filter away from the base substrate.

25. The display device according to claim 24, wherein the surface of the first color filter on the side of the first color filter away from the base substrate comprises a first central region and a first edge region surrounding the first central region; and
wherein the micro bumps in the first edge region have a dimension greater than the dimension of the micro bumps of the surface of the second color filter on the side of the second color filter away from the base substrate and the dimension of the micro bumps of the surface of the third color filter on the side of the third color filter away from the base substrate.

26. The display device according to claim 25, wherein the micro bumps of the surface of the first color filter on the side of the first color filter away from the base substrate have dimensions decreased from an edge of the first color filter to a center of the first color filter, so that an average dimension of the micro bumps in the first edge region of the first color filter is greater than an average dimension of the micro bumps in the first central region of the first color filter.

27. The display device according to any one of claims 24 to 26, wherein the surface of the second color filter on the side of the second color filter away from the base substrate comprises a second central region and a second edge region surrounding the second central region; and
wherein the micro bumps in the second edge region have a dimension less than a dimension of the micro bumps in the second central region, and the micro bumps in a first edge region of the first color filter have a dimension greater than the dimension of the micro bumps in the second central region of the second color filter.

28. The display device according to any one of claims 24 to 27, wherein the micro bumps of the surface of the third color filter on the side of the third color filter away from the base substrate have a substantially same dimension, and the micro bumps in the second central region of the second color filter have a dimension greater than a dimension of the micro bumps of the third color filter.

29. The display device according to any one of claims 24 to 28, wherein the first color filter, the second color filter, and the third color filter are provided in a direction parallel to the base substrate and overlap with each other; and
wherein a thickness difference between any two of the first color filter, the second color filter, and the third color filter is less than a width of an overlapping portion between the any two of the first color filter, the second color filter, and the third color filter, and the width of the overlapping portion is a dimension of the overlapping portion in the direction parallel to the base substrate.

30. The display device according to any one of claims 1 to 14, further comprising:
a first planarization layer on a side of the color filter layer away from the base substrate, wherein the color filter layer comprises a plurality of color filters corresponding one-to-one with the plurality of light-emitting units, the plurality of color filters are provided in a direction parallel to the base substrate and overlap with each other, and a ratio of a thickness of the first planarization layer to a width of an overlapping portion between any two of the plurality of color filters is within a range of 1 to 1.8; and
a second planarization layer between the color filter layer and the encapsulation layer, wherein a thickness of the second planarization layer is less than the thickness of the first planarization layer, and a thickness difference between any two of the plurality of color filters is less than the thickness of the second planarization layer.

31. A display panel comprising a plurality of display devices, wherein the display device is the display device according to any one of claims 1 to 30.

32. The display device according to claim 31, wherein the display panel comprises a display region and a peripheral region on at least one side of the display region, the display device is located in the display region, and a light shielding layer is provided in the peripheral region; and
wherein the light shielding layer comprises a plurality of sub-layers stacked in a direction perpendicular to the base substrate, each of the plurality of sub-layers is made of a material identical to a material of one of a plurality of color filters in the color filter layer, a roughness of a surface of a top sub-layer among the plurality of sub-layers on a side of the top sub-layer away from the base substrate is greater than a roughness of a surface of any of others of the plurality of sub-layers, and the top sub-layer is a sub-layer farthest from the base substrate among the plurality of sub-layers.

33. The display device according to claim 32, wherein the surface of the top sub-layer on the side of the top sub-layer away from the base substrate has a fourth central region and a fourth edge region surrounding the fourth central region, and a roughness of the fourth central region is greater than a roughness of the fourth edge region.

34. The display device according to any one of claims 31 to 33, wherein the peripheral region surrounds the display region, and the light shielding layer extends along the peripheral region, so that a projection of the light shielding layer on the base substrate is in a shape of a circular strip.

35. A method for manufacturing the display device according to any one of claims 1 to 30, comprising:
forming a plurality of light-emitting units on the base substrate;
forming an encapsulation layer covering at least one light-emitting unit;
forming a color filter material layer on a side of the encapsulation layer away from the base substrate;
coating a photosensitive material on the color filter material layer, so that the color filter material layer is completely covered by the photosensitive material; and
removing the photosensitive material and a portion of the color filter material layer through an etch-back process to obtain a color filter layer,
wherein the color filter layer comprises a first surface and a second surface opposite to each other in a direction perpendicular to the base substrate, and a roughness of the first surface is greater than a roughness of the second surface.

36. The method according to claim 35, further comprising: forming a plurality of lenses corresponding one-to-one with the plurality of light-emitting units on a side of the color filter layer away from the base substrate.

37. The method according to claim 35, wherein the photosensitive material is a photoresist, and an etching selection ratio between the photoresist and a material of the color filter material layer is substantially 1:1.

38. The method according to any one of claims 35 to 37, wherein the removing the photosensitive material and a portion of the color filter material layer through an etch-back process comprising:
etching the color filter material layer coated with the photosensitive material until a thickness of the color filter material layer is reduced to a first thickness; and
over-etching the color filter material layer with the first thickness until the thickness of the color filter material layer is further reduced to a second thickness.

39. The method according to any one of claims 35 to 38, further comprising: forming a first planarization layer on the color filter layer before forming a plurality of lenses.
